(19) Europäisches Patentamt
European Patent Office
Office européen des brevets

(11) **EP 2 422 874 A1**

(12) **EUROPEAN PATENT APPLICATION**

(43) Date of publication:
**29.02.2012 Bulletin 2012/09**

(51) Int Cl.:
**B01J 19/00** *(2006.01)*

(21) Application number: **10305933.3**

(22) Date of filing: **31.08.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Corning Incorporated
Corning NY 14831 (US)**

(72) Inventors:
• **Friske, Mark Stephen
Campbell, New York, 14821 (US)**

• **Mabrut, Mickael
77210, Samoreau (FR)**
• **Marques, Paulo Gaspar Jorge
77300, Fontainebleau (FR)**
• **Sutherland, James Scott
Corning, New York, 14831 (US)**
• **Tracy, Ian David
Horseheads, New York, 14845 (US)**

(74) Representative: **Le Roux, Martine et al
Cabinet Beau de Loménie
158, rue de l'Université
75340 Paris Cedex 07 (FR)**

(54) **Fluidic modules with enhanced thermal characteristics**

(57) A fluidic module (100) is provided comprising at least two independent sets (10A,10B) of fluid microchannels (10), a network of glass channel walls (20), one or more thermal exchange partitions (30), and one or more bonding layers (40). The network of glass channel walls (20) defines fluid flow paths of the fluid microchannels (10).The fluid microchannels (10) are configured such that at least a portion of the fluid flow path of one set of microchannels (10A) is partitioned from a portion of the fluid flow path of another set of microchannels (10B) by a thermal exchange partition (30). The thermal exchange partition (30) comprises a non-glassy composition having a thermal conductivity greater than approximately 15 W/(m'K). Respective channel wall end portions (25) of the network of channel walls (20) interface with the thermal exchange partition (30) via one or more bonding pads defined by the bonding layer (40). The bonding layer (40) comprises a glass composition having a thermal conductivity that is less than the thermal conductivity of the thermal exchange partition (30) and a coefficient of thermal expansion that approximates the coefficient of thermal expansion of the thermal exchange partition (30). The bonding pads defined by the bonding layer (40) lie between the channel wall end portions (25) of the network of glass channel walls (20) and the thermal exchange partition (30) and the bonding layer (40) extends at least partially along the thermal exchange partition (30) into the fluid flow paths of the fluid microchannels (10), as defined by the network of glass channel walls (20).

Fig. 2

EP 2 422 874 A1

**Description**

BACKGROUND

The present disclosure relates to fluidic modules including, but not limited to, microreactors, microstructured reactors, microchannel reactors, microchannel heat exchangers and other microfluidic devices. Regardless of the particular nomenclature utilized, a fluidic module can be used to confine a sample for fluid processing. The sample can be moving or static, although it is typically a moving sample. In some cases, the fluid processing involves the analysis of chemical reactions. Fluid processing may also be executed as part of a manufacturing process utilizing two or more distinct reactants. A moving or static target sample may also be confined as heat is exchanged between the sample and an associated heat exchange fluid.

Typical dimensions of the confined spaces of a fluidic module are on the order of about 1 mm. These confined spaces are often configured as microchannels. The relatively small internal dimensions of the microchannels provide significantly higher mass and heat transfer rates within the fluidic module than in more traditional larger-scale fluid processing environments. In addition, the aforementioned fluidic modules offer many other advantages over conventional scale reactors, including improvements in energy efficiency, reaction speed, reaction yield, safety, reliability, scalability, etc.

BRIEF SUMMARY

Fluidic modules are often used in processes where heat transfer efficiency is a significant concern. For example, in some module configurations, thermal energy is transferred across a channel boundary from a reaction fluid to the ambient or to a heat exchange fluid in an adjacent channel. The present inventors have recognized that the heat transfer efficiency of fluidic modules can be a function of many factors, many of which are associated with the channel boundary or the walls separating the reaction fluid from the ambient or the heat exchange fluid. For example, the thermal conductivity of the separating wall plays a significant role in heat transfer efficiency. In addition, the thermal path length of the separating walls and other materials through which heat must flow to transfer thermal energy also has a significant effect on heat transfer efficiency.

In order to reduce resistance to heat transfer, fluidic modules can be designed to maximize thermal conductance through, for example, the use of materials with good thermal conductivity and low wall thicknesses. However, the ability to do this can often be in conflict with other requirements of the fluidic module including, for example, the need for corrosion-resistant, chemically-durable materials, the need for resistance to high pressures in operation, and the requirements and limitations of the process by which the fluidic module is manufactured. The concepts of the present disclosure are intended to help address these design constraints while enhancing heat transfer efficiency in fluidic modules.

According to one embodiment of the present disclosure, a fluidic module is provided comprising at least two independent sets of fluid microchannels, a network of glass channel walls, one or more thermal exchange partitions, and one or more bonding layers. The network of glass channel walls defines fluid flow paths of the fluid microchannels. The fluid microchannels are configured such that at least a portion of the fluid flow path of one set of microchannels is partitioned from a portion of the fluid flow path of another set of microchannels by a thermal exchange partition. The thermal exchange partition comprises a non-glassy composition having (characterized by) a thermal conductivity greater than (approximately) 15 W/(mK). Respective channel wall end portions of the network of channel walls interface with the thermal exchange partition via one or more bonding pads defined by the bonding layer. The bonding layer comprises a glass composition having (characterized by) a thermal conductivity that is less than the thermal conductivity of the thermal exchange partition and (by) a coefficient of thermal expansion that approximates the coefficient of thermal expansion of the thermal exchange partition (the residual match between the two coefficients of thermal expansion is advantageously in the range $\pm$ 200 ppm). The bonding pads defined by the bonding layer lie between the channel wall end portions of the network of glass channel walls and the thermal exchange partition and the bonding layer extends at least partially along the thermal exchange partition into the fluid flow paths of the fluid microchannels, as defined by the network of glass channel walls.

BRIEF DESCRIPTION OF THE SEVERAL VIEWS OF THE DRAWINGS

The following detailed description of specific embodiments of the present disclosure can be best understood when read in conjunction with the following drawings, where like structure is indicated with like reference numerals and in which:

Fig. 1 is a schematic illustration of a portion of a fluidic module according to one embodiment of the present disclosure;

Fig. 2 is a schematic illustration of a portion of a fluidic module according to another embodiment of the present disclosure; and

Fig. 3 is a schematic illustration of a portion of a fluidic module according to yet another embodiment of the present disclosure.

DETAILED DESCRIPTION

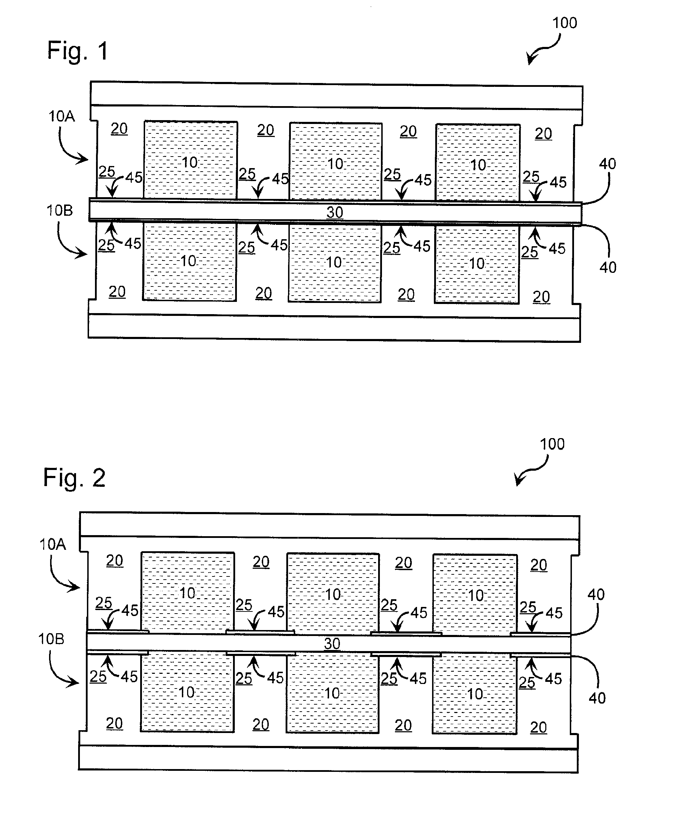

Referring initially to Fig. 1, which is a schematic illustration of a portion of a fluidic module according to one embodiment of the present disclosure, a fluidic module 100 is provided comprising two independent sets 10A, 10B of fluid microchannels 10, a network of glass channel walls 20, a thermal exchange partition 30, and a bonding layer 40 defining a plurality of bonding pads 45.

The network of glass channel walls 20 can be configured to define the fluid flow paths of the fluid microchannels 10 in a variety of configurations, the particular design of which is beyond the scope of the present disclosure and can be realized from a variety of publications relevant to fluidic modules including, for example, US Pub. No. 2009/0139590 and U.S. Patent Nos. 7,297,324, 6,143,943, etc. For clarity, the fluid microchannels 10 are illustrated in cross section, with adjacent independent sets of fluid microchannels 10 defining parallel flow paths.

The fluid microchannels 10 are configured such that at least a portion of the fluid flow path of one set of microchannels is partitioned from a portion of the fluid flow path of another set of microchannels by the thermal exchange partition 30. The thermal exchange partition 30 comprises a non-glassy composition characterized by a thermal conductivity greater than (approximately) 15 W/(m K). For example, and not by way of limitation, it is contemplated that the thermal exchange partition 30 may be an alumina ceramic, silicon carbide, silicon, silicon aluminum nitride, silicon nitride, a steatite ceramic, molybdenum, tantalum, yttrium, or combinations thereof and may comprise a single or multi-layer structure, with each layer of the structure comprising a non-glassy composition.

As is illustrated in Fig. 1., the respective channel wall end portions 25 of the network of channel walls 20 interface with the thermal exchange partition 30 via the bonding pads 45 defined by the bonding layer 40. To facilitate bonding, the bonding layer 40 comprises amorphous glass, a glass ceramic, or a glass composite, all or any of which are referred to herein generally as a glass composition. Due to its glassy composition, the thermal conductivity of the bonding layer 40 is less than the thermal conductivity of the thermal exchange partition 30. The range of values for thermal conductivity for glasses at room temperature extends from 1.38 W/(m·K) (pure quartz glass) to about 0.5 W/(m·K) (high lead containing glasses). The most commonly used silicate glasses have values between 0.9 and 1.2 W/(m·K). In contrast, the material forming the thermal exchange partition will have a thermal conductivity that is at least one order of magnitude larger than the thermal conductivity of the aforementioned glasses, i.e., above (approximately) 15 W/(m·K).

The composition of the bonding layer 40 is tailored such that its coefficient of thermal expansion (CTE) approximates the CTE of the thermal exchange partition 30. For example, the present inventors have recognized that typical materials used for the thermal exchange partition 30 will exhibit a coefficient of thermal expansion (CTE) in the range of 50-85 x$10^{-17}$/°C, preferably in the range of 55-80x$10^{-7}$/°C (at 300°C). Accordingly, the composition of the bonding layer 40 should be tailored to approximate this CTE range.

For example, and not by way of limitation, it is contemplated that the bonding layer should be tailored to comprise between approximately 75 mol% and approximately 80 mol% silica and may comprise a zirconia and alumina containing silicate glass. Suitable glass ceramics include, but are not limited to, cordierite based glass ceramics with additives designed to enable full densification through sintering. Suitable glass composites include but are not limited to those disclosed in US Patent Publications Nos. 2010-0071418 ("Methods for Forming Compositions Containing Glass") and 2008-0230951 ("Methods for Making Microfludic Devices and Devices Produced Thereof").

More specifically, the present inventors have recognized that the durable frit disclosed in US Pub. No. 2009/0139590 can be employed as the bonding layer 40 presented herein. In addition, it is contemplated that the network of glass channel walls 20 may also comprise between approximately 75 mol% and approximately 80 mol% silica and may further be formed from the same composition as the bonding layer 40.

The bonding layer is preferably a glass material that can produce reliable, robust and hermetic structures through powder processing and should also be chemically compatible with alumina ceramics (i.e., it should not tend to cause glass immiscibility or devitrification). The glass material of the bonding layer should have good wetting and flow characteristics during thermal processing, particularly with relation to alumina particles or structures. For example, it is contemplated that the bonding layer improves the adhesion and the flow of the glass frit onto the thermal exchange partition which may desirably be an alumina ceramic.

For applications involving the synthesis of chemicals, preferred glass materials are generally inert and resist a broad range of corrosive environments at both extremes of pH. Finally, the thermal expansion characteristics of the layer glass should be compatible with the material of the thermal exchange partition in order to give low seal stress over the fabrication and working temperature ranges of the product. For example, the thermal expansion characteristics of the layer glass may be selected so that the layer is under low compression over the working temperature ranges of the product to avoid tensile fracture.

As is illustrated in Fig. 1 the bonding pads 45 defined by the bonding layer lie between the channel wall end portions 25 and the thermal exchange partition 30. To further enhance bond strength and durability, the bonding layer 40 extends at least partially along the thermal exchange partition 30 into the fluid flow paths of the fluid microchannels 10. Fig. 2, which is described in further detail below, illustrates partial extension of the bonding pads 45 of the bonding layer 40 into the fluid flow paths.

In Fig. 1, the bonding layer 40 extends along the thermal exchange partition 30 across the entirety of the fluid flow paths of the fluid microchannels 10. To optimize thermal transfer between adjacent microchannels the thickness of the bonding layer 40 can be tailored to be less than 100 $\mu$m. Globally, it is contemplated that it is likely to be advantageous to ensure that the combined thicknesses of (i) the bonding layer in a fluid microchannel 10 of one set 10A of microchannels, (ii) the bonding layer in an adjacent fluid microchannel 10 of another set 10B of microchannels, and (iii) an intervening portion of the thermal exchange partition 30 is less than approximately 400 $\mu$m.

In the illustrated embodiment, the overall heat transfer coefficient $U$ between the adjacent fluid microchannels is as follows:

$$U = \cfrac{1}{\cfrac{1}{h_{in}} + \left( \cfrac{\delta_1}{\lambda_1} + \cfrac{\delta_2}{\lambda_2} + \cfrac{\delta_3}{\lambda_3} \right) + \cfrac{1}{h_{out}}}$$

where $h_{in}$ and $h_{out}$ represent heat quantities in the adjacent fluid microchannels, $\delta_1$, $\delta_2$, and $\delta_3$ represent the respective thickness of the bonding layers and the thermal exchange partition between the adjacent fluid microchannels, and $\lambda_1$, $\lambda_2$, and $\lambda_3$ represent the respective thermal conductivities of the bonding layers and the thermal exchange partition.

Fig. 2 presents a schematic illustration of a portion of a fluidic module 100 employing a patterned bonding layer. In Fig. 2, the bonding layer is patterned to define limited bonding pads 45 such that fluid within the fluid flow paths of the fluid channels 10 contacts the thermal exchange partition 30 directly. The bonding layer is patterned such that the bonding pads 45 and respective channel wall end portions 25 of the network of channel walls 20 are extra-congruent. Specifically, the bonding pads 45 are slightly oversized relative to the channel wall end portions 25 to help ensure that edge portions of the channel wall end portions will not hang cantilevered over the bonding pads - a condition which would limit bond strength and durability. By over-sizing the bonding pads by, for example, up to approximately 1 mm, it is contemplated that any misalignment tolerances arising from wall or bonding pad molding processes, alignment errors when the walls and pads are brought into contact, etc., can be accounted for.

Regarding the aforementioned reference to the bonding pads 45 and the channel wall end portions 25 as being "extra-congruent," as is illustrated in Figs. 1-3, the bonding pads 45 and the channel wall end portions 25 are "congruent" in the sense that the full extent of each of the illustrated wall end portions 25 is occupied by a portion of the bonding pads 45. In addition, the illustrated bonding pads 45 are "extra" congruent because they extends along the thermal exchange partition 30 beyond the perimeter of the individual channel wall end portions 25.

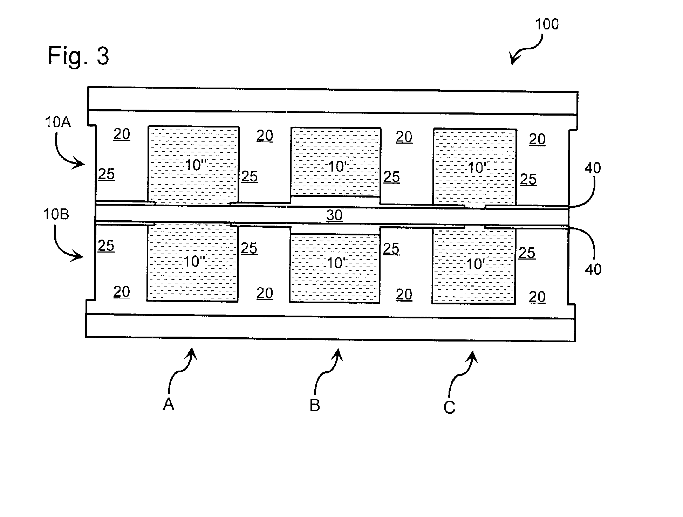

Fig. 3, which is also a schematic illustration of a portion of a fluidic module 100 employing a patterned bonding layer 40, further illustrates a module configuration that defines relatively adiabatic fluid microchannels 10' and relatively diabatic fluid microchannels 10" in a single fluidic module comprising the patterned bonding layer 40. As is illustrated in Fig. 3, the bonding layer 40 is tailored to occupy portions of the fluid flow paths of the fluid microchannels 10', 10" to varying degrees, with respect to either the localized thickness of the bonding layer 40 or the localized extent of the bonding layer 40.

More specifically, referring to adjacent channel pairs A, B, and C, illustrated in Fig. 3, it is noted that adjacent pair A will be diabatic, relative to the other channel pairs illustrated in Fig. 3 because fluid flowing within the adjacent channels 10" will be in contact with the thermal exchange partition 30 to a relatively high degree. In contrast, adjacent pairs B and C will be relatively adiabatic because fluid flowing within the adjacent channels 10' will be thermally insulated from the thermal exchange partition 30 by the expanded bonding layer in the channels 10'. Stated differently, the bonding layer 40 occupies more of the relatively adiabatic fluid microchannels 10', as compared to the relatively diabatic fluid microchannels 10".

Although the fluidic modules of Figs. 1-3 have been illustrated with only two independent sets of fluid microchannels to preserve clarity, it is contemplated that, in many cases, the fluidic module will comprise three independent sets of fluid microchannels - a central set of microchannels containing reactive chemicals and two external sets of microchannels containing heat exchange fluids. It is also noted that the present disclosure is not limited to specific fluidic module configurations or the use of specific microchannel configurations. For example, and not by way of limitation, it is contemplated that fluidic modules according to the present disclosure can be configured to distribute a single reactant, mix two reactants, provide for heat exchange between one or more reactants and a thermal fluid, or to provide quench-flow, hydrolysis, residence time, or other similar functions.

To manufacture the aforementioned fluidic modules, it is contemplated that the network of channel walls may be formed from any of a variety of bulk glass structure fabrication processes. In contrast, the bonding layers described herein are preferably formed by processes that are more suitable for forming relatively thin patterned or non-patterned glass layers including, but not limited to, tape casting, dip or spin coating, spray coating, screen printing, inkjet printing, etc. Particular embodiments of the present disclosure are accordingly drawn to fabrication methodologies that combine bulk glass structure fabrication processes and the aforementioned processes for forming relatively thin patterned or non-patterned glass layers. Still further embodiments of the present disclosure contemplate non-glassy structures, i.e., fluidic modules employing metallic, ceramic and/or graphitic components.

For the purposes of describing and defining the present invention, it is noted that a non-glassy composition will comprise less than 10% by weight silica. It is also noted that recitations herein of "at least one" component, element, etc., should not be used to create an inference that the alternative use of the articles "a" or "an" should be limited to a single component, element, etc.

It is noted that recitations herein of a component of the present disclosure being "configured" in a particular way, to embody a particular property, or function in a particular manner, are structural recitations, as opposed to recitations of intended use. More specifically, the references herein to the manner in which a component is "configured" denotes an existing physical condition of the component and, as such, is to be taken as a definite recitation of the structural characteristics of the component.

The methods and/or devices disclosed herein are generally useful in performing any process that involves mixing, separation, extraction, crystallization, precipitation, or otherwise processing fluids or mixtures of fluids, including multiphase mixtures of fluids-and including fluids or mixtures of fluids including multiphase mixtures of fluids that also contain solids-within a microstructure. The processing may include a physical process, a chemical reaction defined as a process that results in the interconversion of organic, inorganic, or both organic and inorganic species, a biochemical process, or any other form of processing. The following non-limiting list of reactions may be performed with the disclosed methods and/or devices: oxidation; reduction; substitution; elimination; addition; ligand exchange; metal exchange; and ion exchange. More specifically, reactions of any of the following non-limiting list may be performed with the disclosed methods and/or devices: polymerisation; alkylation; dealkylation; nitration; peroxidation; sulfoxidation; epoxidation; ammoxidation; hydrogenation; dehydrogenation; organometallic reactions; precious metal chemistry/ homogeneous catalyst reactions; carbonylation; thiocarbonylation; alkoxylation; halogenation; dehydrohalogenation; dehalogenation; hydroformylation; carboxylation; decarboxylation; amination; arylation; peptide coupling; aldol condensation; cyclocondensation; dehydrocyclization; esterification; amidation; heterocyclic synthesis; dehydration; alcoholysis; hydrolysis; ammonolysis; etherification; enzymatic synthesis; ketalization; saponification; isomerisation; quaternization; formylation; phase transfer reactions; silylations; nitrile synthesis; phosphorylation; ozonolysis; azide chemistry; metathesis; hydrosilylation; coupling reactions; and enzymatic reactions.

It is noted that terms like "preferably," "commonly," and "typically," when utilized herein, are not utilized to limit the scope of the claimed invention or to imply that certain features are critical, essential, or even important to the structure or function of the claimed invention. Rather, these terms are merely intended to identify particular aspects of an embodiment of the present disclosure or to emphasize alternative or additional features that may or may not be utilized in a particular embodiment of the present disclosure.

For the purposes of describing and defining the present invention it is noted that the terms "substantially" and "approximately" are utilized herein to represent the inherent degree of uncertainty that may be attributed to any quantitative comparison, value, measurement, or other representation. The terms "substantially" and "approximately" are also utilized herein to represent the degree by which a quantitative representation may vary from a stated reference without resulting in a change in the basic function of the subject matter at issue.

Having described the subject matter of the present disclosure in detail and by reference to specific embodiments thereof, it is noted that the various details disclosed herein should not be taken to imply that these details relate to elements that are essential components of the various embodiments described herein, even in cases where a particular element is illustrated in each of the drawings that accompany the present description. Rather, the claims appended hereto should be taken as the sole representation of the breadth of the present disclosure and the corresponding scope of the various inventions described herein. Further, it will be apparent that modifications and variations are possible without departing from the scope of the invention defined in the appended claims. More specifically, although some aspects of the present disclosure are identified herein as preferred or particularly advantageous, it is contemplated that the present disclosure is not necessarily limited to these aspects.

It is noted that one or more of the following claims utilize the term "wherein" as a transitional phrase. For the purposes of defining the present invention, it is noted that this term is introduced in the claims as an open-ended transitional phrase that is used to introduce a recitation of a series of characteristics of the structure and should be interpreted in like manner as the more commonly used open-ended preamble term "comprising."

**Claims**

1. A fluidic module (100) comprising at least two independent sets (10A,10B) of fluid microchannels (10), a network of glass channel walls (20), one or more thermal exchange partitions (30), and one or more bonding layers (40), wherein:

   the network of glass channel walls (20) defines fluid flow paths of the fluid microchannels (10);
   the fluid microchannels (10) are configured such that at least a portion of the fluid flow path of one set (10A, 10B) of microchannels (10) is partitioned from a portion of the fluid flow path of another set of microchannels (10) by a thermal exchange partition (30);
   the thermal exchange partition (30) comprises a non-glassy composition having a thermal conductivity greater than 15 W/(m K);
   respective channel wall end portions (25) of the network of channel walls (20) interface with the thermal exchange partition (30) via one or more bonding pads (45) defined by the bonding layer (40);
   the bonding layer (40) comprises a glass composition having a thermal conductivity that is less than the thermal conductivity of the thermal exchange partition (30) and a coefficient of thermal expansion that approximates the coefficient of thermal expansion of the thermal exchange partition (30);
   the bonding pads (45) defined by the bonding (40) layer lie between the channel wall end portions (25) of the network of glass channel walls (20) and the thermal exchange partition (30); and
   the bonding layer (40) extends at least partially along the thermal exchange partition (30) into the fluid flow paths of the fluid microchannels (10), as defined by the network of glass channel walls (20).

2. The fluidic module (100) as claimed in claim 1 wherein the bonding layer (40) is patterned such that fluid within the fluid flow paths of the fluid channels (10) contacts the thermal exchange partition (30) directly.

3. The fluidic module (100) as claimed in either of claims 1 and 2 wherein:

   the bonding layer (40) is patterned such that the bonding pads (45) and respective channel wall end portions (25) of the network of channel walls (20) are extra-congruent; and
   the bonding pads (45) extend along the thermal exchange partition (30) only partially into the fluid flow paths of the fluid microchannels (10).

4. The fluidic module (100) as claimed in claim 3 wherein the bonding pads (45) extend up to 1000 $\mu$m along the thermal exchange partition (30) into the fluid flow paths of the fluid microchannels (10).

5. The fluidic module (100) as claimed in any of claims 1-4 wherein the bonding layer (40) occupies portions of the fluid flow paths of the fluid microchannels (10) to varying degrees so as to define relatively adiabatic fluid microchannels (10') and relatively diabatic fluid microchannels (10").

6. The fluidic module (100) as claimed in claim 5 wherein the bonding layer (40) extends farther along the thermal exchange partition (30) in the relatively adiabatic fluid microchannels (10'), as compared to the relatively diabatic (10") fluid microchannels, or has a greater thickness in the relatively adiabatic fluid microchannels (10'), as compared to the relatively diabatic (10") fluid microchannels, or both.

7. The fluidic module (100) as claimed in claim 1 wherein the bonding layer (40) extends along the thermal exchange partition (30) across the entirety of the fluid flow paths of the fluid microchannels (10).

8. The fluidic module (100) as claimed in claim 7 wherein the thickness of the bonding layer (40) is less than 100 $\mu$m.

9. The fluidic module (100) as claimed in either of claims 7 and 8 wherein the combined thicknesses of (i) the bonding layer (40) in a fluid microchannel (10) of one set (10A) of fluid microchannels 10, (ii) the bonding layer (40) (4) in an adjacent fluid microchannel (10) of another set (10B) of fluid microchannels (10), and (iii) an intervening portion of the thermal exchange partition (30) is less than approximately 400 $\mu$m.

10. The fluidic module (100) as claimed in any of claims 1-9 wherein the bonding layer (40) comprises between approximately 75 mol% and approximately 80 mol% silica.

11. The fluidic module (100) as claimed in any of claims 1-10 wherein the bonding layer (40) comprises a zirconia and alumina containing silicate glass.

12. The fluidic module (100) as claimed in any of claims 1-11 wherein the thermal exchange partition (30) comprises an alumina ceramic.

13. The fluidic module (100) as claimed in any of claims 1-11 wherein the thermal exchange partition (30) comprises alumina ceramic, silicon carbide, silicon, silicon aluminum nitride, silicon nitride, a steatite ceramic, molybdenum, tantalum, yttrium, or combinations thereof.

14. The fluidic module (100) as claimed in any of claims 1-13 wherein the network of glass channel walls (20) comprises between approximately 75 mol% and approximately 80 mol% silica.

15. The fluidic module (100) as claimed in any of claims 1-14 wherein materials used to form the thermal exchange partition (30) are **characterized by** a CTE in the range of 50-85 $\times 10^{-7}$/°C at 300°C, preferably in the range of 55-80$\times 10^{-7}$/°C at 300°C.

## Fig. 1

100

10A

20    20    20    20

25  45    10    25  45    10    25  45    10    25  45

10B                                                                      40

25  45    25  45    25  45    25  45

30

20    10    20    10    20    10    20

40

## Fig. 2

100

10A

20    20    20    20

25  45    10    25  45    10    25  45    10    25  45

10B                                                                      40

25  45    25  45    25  45    25  45

30

20    10    20    10    20    10    20

40

40

**Fig. 3**

Europäisches
Patentamt

European
Patent Office

Office européen
des brevets

# EUROPEAN SEARCH REPORT

Application Number

EP 10 30 5933

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2009/139590 A1 (MARQUES PAULO GASPAR JORGE [FR]) 4 June 2009 (2009-06-04) * paragraphs [0007] - [0012], [0044], [0045], [0048], [0067] * * claims 8,9,15; table I * * figures 1A-1D * | 1-15 | INV. B01J19/00 |
| X | WO 2008/143918 A1 (CORNING INC [US]; MARQUES PAULO G [FR]; MORENA ROBERT M [US]; TANNER C) 27 November 2008 (2008-11-27) * paragraphs [0032] - [0034], [0045], [0046], [0054], [0060], [0061] * * figures 1,4A-4C,6 * * tables 2, 4 * | 1-15 | |
| A | US 2004/206391 A1 (GUZMAN GUILLAUME [FR] ET AL) 21 October 2004 (2004-10-21) * paragraphs [0065] - [0091] * * figures 1-5 * | 1-15 | |
| A | EP 1 927 576 A1 (CORNING INC [US]) 4 June 2008 (2008-06-04) * paragraphs [0024] - [0033] * * figures 1A-1E; 2 * | 1-15 | TECHNICAL FIELDS SEARCHED (IPC) B01J C03C C03B B81C |
| A | WO 2008/031968 A1 (SAINT GOBAIN [FR]; GASCON HELENE [FR]; DUISIT GERALDINE [FR]; BRUNET E) 20 March 2008 (2008-03-20) * the whole document * | 1-15 | |
| A | EP 1 415 706 A1 (CORNING INC [US]) 6 May 2004 (2004-05-06) * the whole document * | 1-15 | |
| E | EP 2 289 845 A1 (CORNING INC [US]) 2 March 2011 (2011-03-02) * the whole document * | 1-15 | |

The present search report has been drawn up for all claims

| Place of search | Date of completion of the search | Examiner |
|---|---|---|
| The Hague | 23 March 2011 | Baumlin, Sébastien |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 10 30 5933

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2011

| Patent document cited in search report | | Publication date | Patent family member(s) | | Publication date |
|---|---|---|---|---|---|
| US 2009139590 | A1 | 04-06-2009 | AU 2008330085 A1 | | 04-06-2009 |
| | | | CA 2706942 A1 | | 04-06-2009 |
| | | | CN 101952214 A | | 19-01-2011 |
| | | | EP 2065347 A1 | | 03-06-2009 |
| | | | KR 20100099212 A | | 10-09-2010 |
| | | | WO 2009070290 A1 | | 04-06-2009 |
| WO 2008143918 | A1 | 27-11-2008 | CN 101687693 A | | 31-03-2010 |
| | | | JP 2010530294 T | | 09-09-2010 |
| | | | KR 20100019520 A | | 18-02-2010 |
| | | | US 2010178214 A1 | | 15-07-2010 |
| US 2004206391 | A1 | 21-10-2004 | NONE | | |
| EP 1927576 | A1 | 04-06-2008 | AT 494260 T | | 15-01-2011 |
| | | | CN 101636345 A | | 27-01-2010 |
| | | | EP 2099708 A1 | | 16-09-2009 |
| | | | JP 2010522641 T | | 08-07-2010 |
| | | | KR 20090096491 A | | 10-09-2009 |
| | | | US 2010068107 A1 | | 18-03-2010 |
| | | | WO 2008066796 A1 | | 05-06-2008 |
| WO 2008031968 | A1 | 20-03-2008 | CA 2662884 A1 | | 20-03-2008 |
| | | | CN 101522556 A | | 02-09-2009 |
| | | | EP 2059473 A1 | | 20-05-2009 |
| | | | FR 2905690 A1 | | 14-03-2008 |
| | | | JP 2010502470 T | | 28-01-2010 |
| | | | KR 20090074193 A | | 06-07-2009 |
| | | | US 2010043494 A1 | | 25-02-2010 |
| EP 1415706 | A1 | 06-05-2004 | AU 2003287247 A1 | | 25-05-2004 |
| | | | CN 1708351 A | | 14-12-2005 |
| | | | JP 2006518269 T | | 10-08-2006 |
| | | | WO 2004039490 A1 | | 13-05-2004 |
| | | | US 2004123626 A1 | | 01-07-2004 |
| EP 2289845 | A1 | 02-03-2011 | WO 2011031432 A2 | | 17-03-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090139590 A
- US 7297324 B
- US 6143943 A
- US 20100071418 A
- US 20080230951 A